# EUROPEAN PATENT APPLICATION

(11) **EP 4 345 893 A1**
(43) Date of publication of application: **03.04.2024**
(21) Application number: 23198531.8
(22) Date of filing: 20.09.2023
(51) Int. Cl.: H01L 23/498, H01L 23/00

(54) **SEMICONDUCTOR DEVICE WITH REDISTRIBUTION METALLIZATION AND METHOD THEREFOR**

(30) Priority: 28.09.2022 US 202217936042
(71) Applicant: NXP B.V., 5656 AG Eindhoven (NL)
(72) Inventor: Mao, Kuan-Hsiang, 5656AG Eindhoven (NL); Liu, Yufu, 5656AG Eindhoven (NL); Huang, Wen Hung, 5656AG Eindhoven (NL); Lo, Tsung Nan, 5656AG Eindhoven (NL)
(74) Representative: Hardingham, Christopher Mark

(57) **Abstract**

A method of manufacturing a semiconductor device is provided. The method includes forming a redistribution layer (RDL) over a semiconductor die. A portion of the RDL contacts a die pad of the semiconductor die. A metal layer is formed on a top surface and sidewalls of the RDL and configured to encase the RDL. A non-conductive layer is formed over the metal layer and underlying RDL. An opening in the non-conductive layer is formed exposing a portion of the metal layer formed on the RDL. An under-bump metallization (UBM) is formed in the opening and conductively connected to the die pad by way of the metal layer and RDL.

## Description

### Background

### Field

This disclosure relates generally to semiconductor device packaging, and more specifically, to a semiconductor device with redistribution metallization and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.

FIG. 1 illustrates, in a simplified plan view, an example semiconductor device having redistribution metallization at a stage of manufacture in accordance with an embodiment.

FIG. 2 through FIG. 10 illustrate, in simplified cross-sectional views, the example semiconductor device taken along line A-A of FIG. 1 at stages of manufacture in accordance with an embodiment.

### Detailed Description

Generally, there is provided, a semiconductor device with a redistribution metallization structure. The semiconductor device includes a plated redistribution layer formed over a semiconductor die and connected to die pads of the semiconductor die. The redistribution layer is formed by way of utilizing a sputtered seed layer in a plating operation. The redistribution layer is formed having a predetermined thickness sufficient to carry large currents, for example. A sputtered metal layer is formed on a top surface and sidewalls of the redistribution layer. The metal layer contacts the seed layer at a perimeter of each patterned shape of the redistribution layer. The metal layer and the seed layer together encase the redistribution layer. A dielectric layer is subsequently formed over the encased redistribution layer. An opening is formed in the dielectric layer to expose a portion of the underlying encased redistribution layer. A second seed layer is formed on the dielectric layer and exposed portion of the metal layer over the redistribution layer. An under-bump metallization is subsequently formed utilizing the second seed layer in a second plating operation. By forming the redistribution metallization structure with the plated redistribution layer encased by sputtered layers (e.g., seed layer, metal layer), improved reliability can be realized over the lifetime of the semiconductor device.

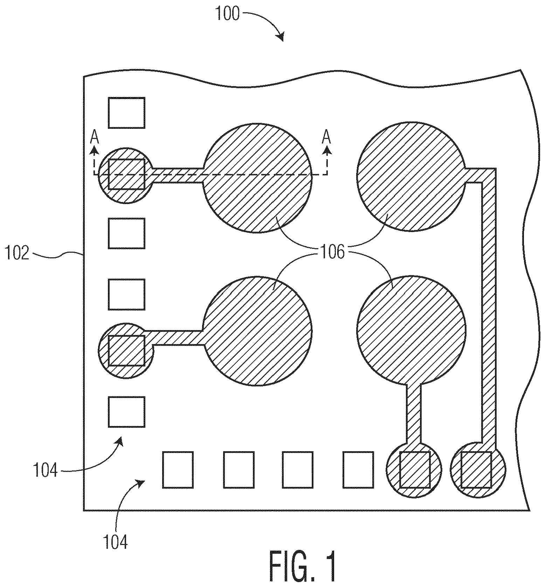

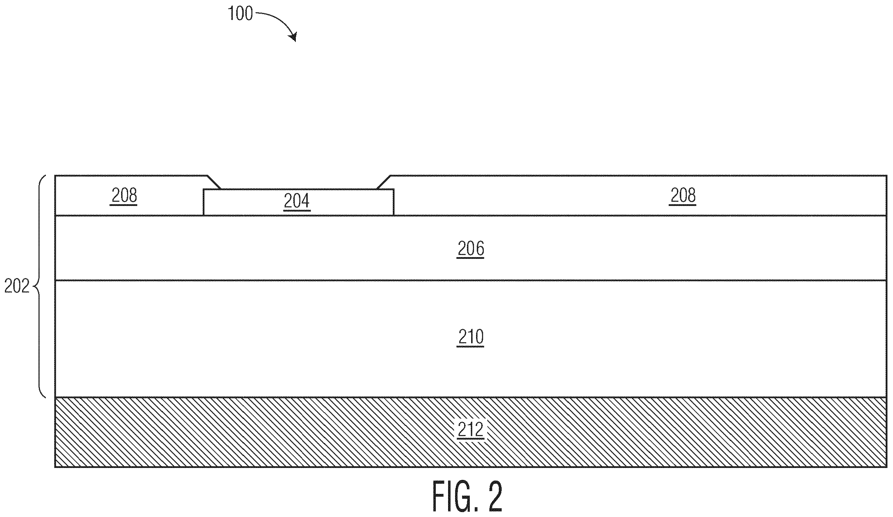

FIG. 1 illustrates, in a simplified plan view, a portion of an example semiconductor device 100 having redistribution metallization at a stage of manufacture in accordance with an embodiment. At this stage, the device 100 includes a semiconductor die 102 including a plurality of die pads 104 and a portion of a redistribution layer (RDL) 106. In this embodiment, the RDL 106 includes patterned features (e.g., shapes) configured to form connections to respective die pads 104. The number and arrangement of die pads 104 and patterned features of the RDL 106 are chosen for illustration purposes. Detailed features of the semiconductor device 100 such as a package encapsulant and intermediate layers disposed between the semiconductor die and the RDL are not shown for illustration purposes. Even though the embodiment of FIG. 1 is depicted in a "fan-in" configuration, embodiments in other configurations (e.g., "fan-out") are anticipated by this disclosure. Cross-sectional views of the example semiconductor device 100 taken along line A-A of FIG. 1 at stages of manufacture are depicted in FIG. 2 through FIG. 10.

FIG. 2 through FIG. 10 illustrate, in simplified cross-sectional views, the example semiconductor device 100 taken along line A-A of FIG. 1 at various stages of manufacture in accordance with an embodiment.

FIG. 2 illustrates, in a simplified cross-sectional view, the example semiconductor device 100 at a stage of manufacture in accordance with an embodiment. At this stage of manufacture, a semiconductor die 202 is at least partially encapsulated with an encapsulant (e.g., epoxy molding compound) 212. In this embodiment, the semiconductor die 202 includes a substrate region (e.g., bulk) 210, an active region (e.g., circuitry, interconnect) 206 formed at an active side of the semiconductor die, a die pad 204 conductively connected to the circuitry and/or interconnect of the active region, and a final passivation layer 208 formed over the active side of the semiconductor die. In some embodiments, the semiconductor die 202 may be provided in a wafer form or portion of a wafer. The semiconductor die 202 may include any number of conductive interconnect layers and passivation layers. For illustration purposes, the die pad 204 at a top surface and the overlying final passivation layer 208 are depicted. In this embodiment, the semiconductor die 202 and die pad 204 depicted in FIG. 2 corresponds to the semiconductor die 102 and die pad 104 depicted along line A-A in FIG. 1.

The semiconductor die 202 is configured and arranged in an active side up orientation. The die pad 204 at the active side is configured for connection to a printed circuit board (PCB) by way of a redistribution layer, under-bump structure, and conductive connectors formed at subsequent stages, for example. The semiconductor die 202 may be formed from any suitable semiconductor material, such as silicon, germanium, gallium arsenide, gallium nitride, silicon nitride, silicon carbide, and the like. The semiconductor die 202 may further include any digital circuits, analog circuits, RF circuits, memory, processor, MEMS, sensors, the like, and combinations thereof.

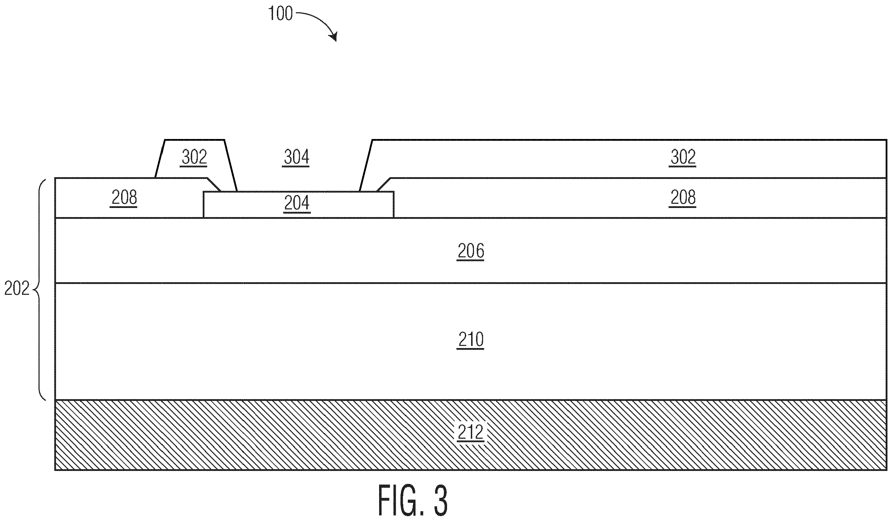

FIG. 3 illustrates, in a simplified cross-sectional view, the example semiconductor device 100 at a subsequent stage of manufacture in accordance with an embodiment. At this stage of manufacture, a first non-conductive (e.g., dielectric) layer 302 is formed over the semiconductor die 202. The non-conductive layer 302 is deposited or otherwise applied on the top surface of the semiconductor die 202. The non-conductive layer 302 may be formed from suitable non-conducting materials such as polybenzoxazole (PBO), polyimide, Ajinomoto build-up film (ABF), and epoxy molding compound, for example. An opening 304 is patterned and formed in the non-conductive layer 302. The opening 304 is formed through the non-conductive layer 302 and located over the die pad 204 such that a substantial portion of a top surface of the die pad 204 is exposed. The opening 304 may be formed using known laser ablation or other etching techniques, for example. In this embodiment, an outer portion of the final passivation layer 208 near the outer edge of the semiconductor die 202 remains exposed (e.g., not covered with the non-conductive layer 302).

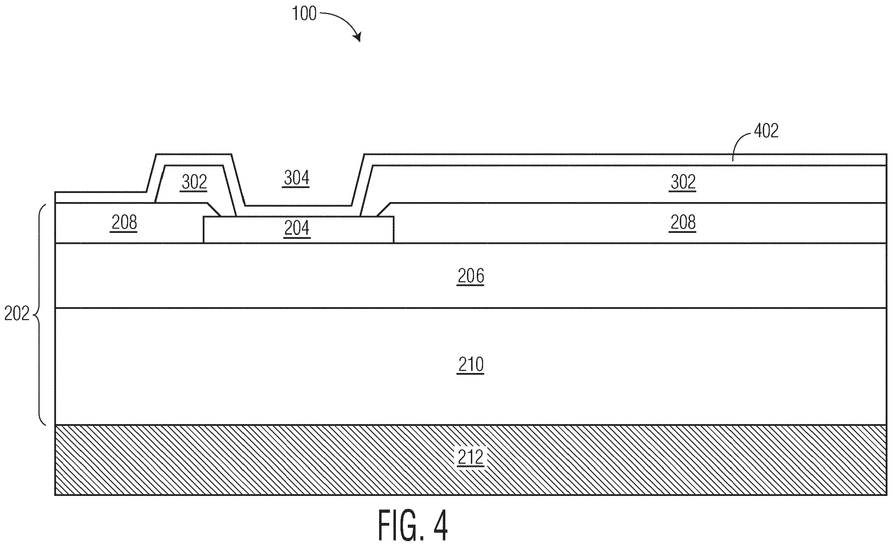

FIG. 4 illustrates, in a simplified cross-sectional view, the example semiconductor device 100 at a subsequent stage of manufacture in accordance with an embodiment. At this stage of manufacture, a first conductive seed layer 402 is formed over the non-conductive layer 302 and exposed portion of the die pad 204. The term "conductive," as used herein, generally refers to electrical conductivity unless otherwise specified. The seed layer 402 may be formed by depositing (e.g., sputtering) a relatively thin (e.g., ~0.1-0.5 microns) metal layer or combination of metal layers suitable as a catalyst for a plating operation at a subsequent stage of manufacturing. For example, the seed layer 402 may be formed from metal materials such as titanium, titanium-tungsten, nickel-vanadium, and the like, plus copper. In this embodiment, the seed layer 402 forms a thin conformal conductive layer on the non-conductive layer 302, exposed die pad 204 in the opening 304, and exposed portions of the final passivation layer 208.

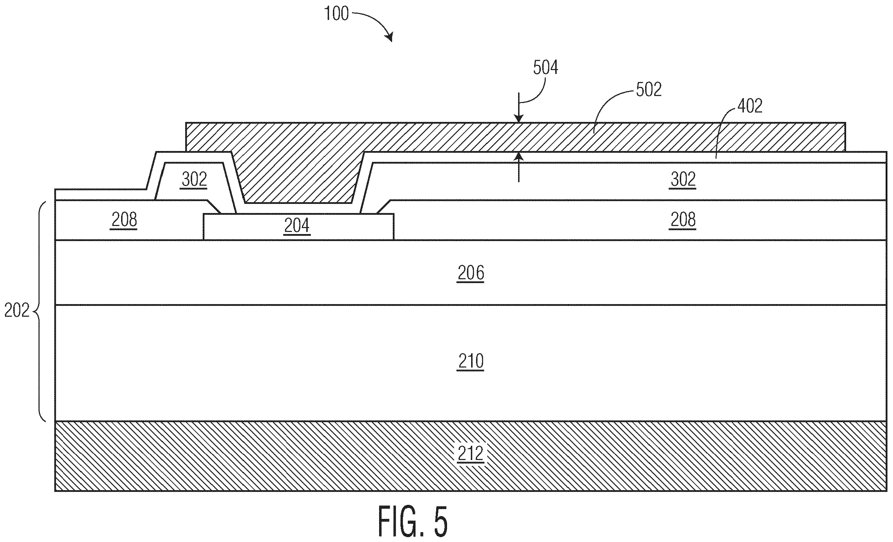

FIG. 5 illustrates, in a simplified cross-sectional view, the example semiconductor device 100 at a subsequent stage of manufacture in accordance with an embodiment. At this stage of manufacture, a conductive RDL 502 is formed over the non-conductive layer 302 and exposed portion of the die pad 204. In this embodiment, the RDL 502 is formed by utilizing the seed layer 402 in a metal (e.g., copper) plating operation. The metal plating operation may include process steps such as patterning for selective electroplating of the RDL 502. The RDL 502 is formed as a conformal conductive layer over the exposed die pad 204 in the opening 304 and predetermined patterned portions of the non-conductive 302 layer. The RDL 502 is conductively connected to the die pad 204 and configured to interconnect the die pad 204 with an under-bump structure formed at a subsequent stage, for example. In this embodiment, the RDL 502 is plated to a predetermined thickness dimension 504 (e.g., in a range of approximately 4 microns and greater) suitable for a high current carrying capacity.

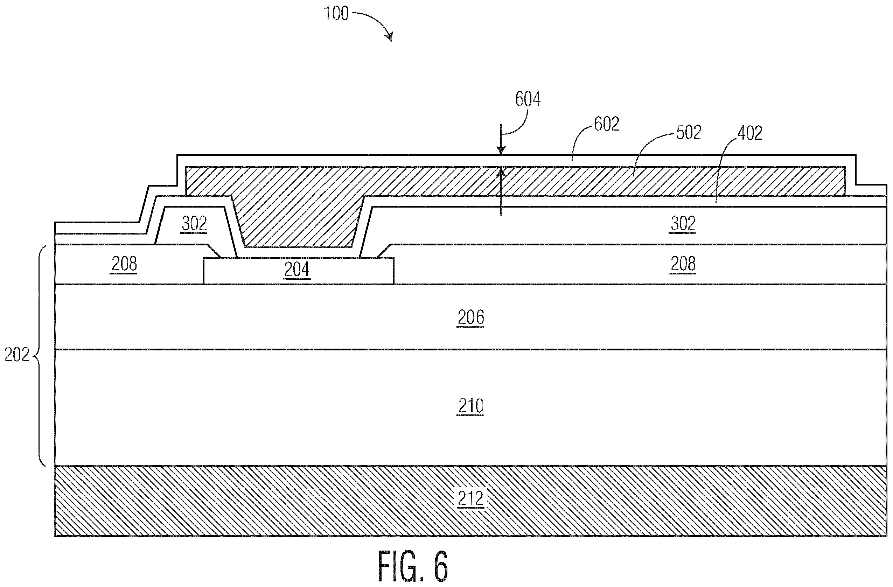

FIG. 6 illustrates, in a simplified cross-sectional view, the example semiconductor device 100 at a subsequent stage of manufacture in accordance with an embodiment. At this stage of manufacture, a thin metal layer 602 is deposited on the exposed portions of the RDL 502. The metal layer 602 may be formed by sputtering a metal material on the top surface and sidewall surfaces of the RDL 502. The metal layer 602 is formed to a predetermined thickness dimension 604 (e.g., in a range of approximately 0.1 microns to 0.5 microns). The metal layer 602 may be formed from one or more metal materials. For example, the metal layer 602 may include metal materials such as titanium, titanium-tungsten, nickel-vanadium, and the like. In this embodiment, the metal layer 602 contacts the seed layer 402 at a perimeter of each patterned feature of the RDL 502 such that the metal layer 602 together with the seed layer 402 encases the RDL 502. In this embodiment, the metal materials of the metal layer 602 and the seed layer 402 are chosen for properties such as inhibiting the metal (e.g., copper) material of the RDL 502 from diffusing into neighboring dielectric material. By encasing the plated RDL 502 in such materials, the overall RDL 502 structure is significantly more robust and less susceptible to reliability concerns such as electromigration as well.

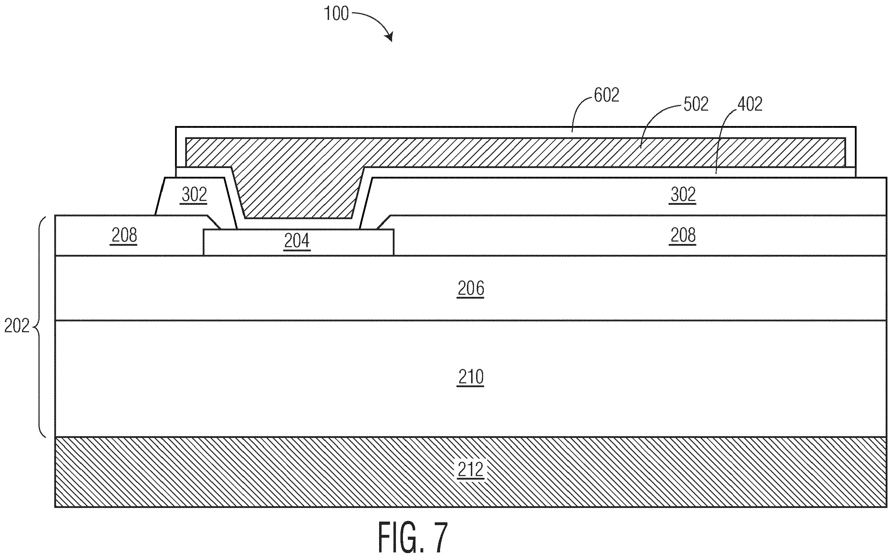

FIG. 7 illustrates, in a simplified cross-sectional view, the example semiconductor device 100 at a subsequent stage of manufacture in accordance with an embodiment. At this stage of manufacture, the metal layer 602 and the underlying seed layer 402 at portions outside of the perimeter of each patterned feature of the RDL 502 are removed. In this embodiment, the metal layer 602 is patterned and etched such that the metal layer 602 on the top surface and sidewall surfaces of the RDL 502 remains after the etch. In this manner, the metal layer 602 and the underlying seed layer 402 are removed while the remaining metal layer 602 together with the seed layer 402 continue to encase (e.g., surround on all sides) the RDL 502.

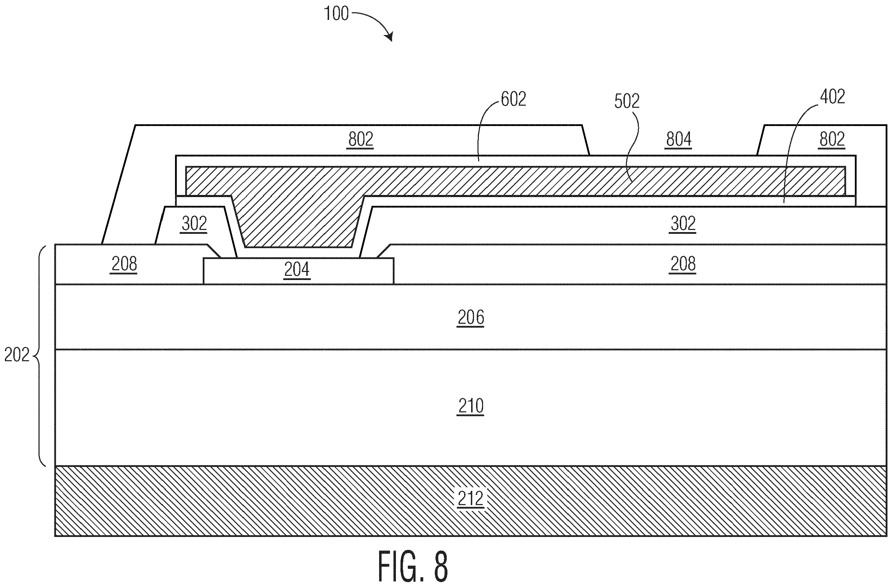

FIG. 8 illustrates, in a simplified cross-sectional view, the example semiconductor device 100 at a subsequent stage of manufacture in accordance with an embodiment. At this stage of manufacture, a second non-conductive (e.g., dielectric) layer 802 is formed over the encased RDL 502 and portions of the first non-conductive layer 302. The non-conductive layer 802 is deposited or otherwise applied on the metal layer 602 covering the RDL 502 and the exposed surface of the non-conductive layer 302. The non-conductive layer 802 may be formed from suitable non-conducting materials such as PBO, polyimide, ABF, and epoxy molding compound, for example. In this embodiment, the non-conductive layer 802 may be characterized as a photo-imageable polymer material (e.g., photosensitive solder mask material) layer. An opening 804 is patterned and formed in the non-conductive layer 802. The opening 804 may be formed using traditional masking and etch techniques, for example.

The opening 804 is formed through the non-conductive layer 802 and located over a portion of the RDL 502 such that a portion of a top surface of the metal layer 602 over the RDL 502 is exposed through the opening. In this embodiment, an outer portion of the non-conductive layer 802 extends toward the outer perimeter of the semiconductor die 202 and is configured to seal (e.g., enclose) an outer edge of the non-conductive layer 302 leaving an outer portion of the final passivation layer 208 exposed (e.g., not covered with the non-conductive layers 302 and 802) near the outer edge of the semiconductor die 202.

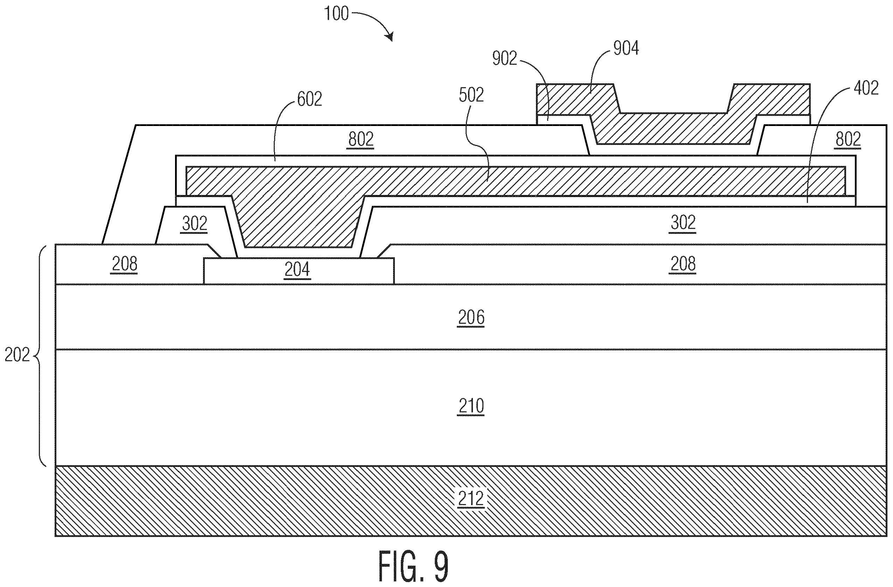

FIG. 9 illustrates, in a simplified cross-sectional view, the example semiconductor device 100 at a subsequent stage of manufacture in accordance with an embodiment. At this stage of manufacture, a second conductive seed layer 902 and under-bump metallization (UBM) 904 are formed over the non-conductive layer 802 and exposed portion of the metal layer 602 over the RDL 502. The seed layer 902 may be formed by depositing (e.g., sputtering) a relatively thin (e.g., ~0.1-0.5 microns) metal layer or combination of metal layers suitable as a catalyst for a plating operation to form the UBM 904, for example. The seed layer 902 may be formed from metal materials such as titanium, titanium-tungsten, nickel-vanadium, and the like, plus copper.

A conductive UBM 904 is formed on the seed layer 902. In this embodiment, the UBM 904 includes copper and is formed by utilizing the seed layer 902 in a copper plating operation. The copper plating operation may be characterized as an electroless process or an electroplating process. The UBM 904 forms a conformal conductive layer over the exposed portion of the metal layer 602 over the RDL 502 at the opening 802 of FIG. 8. After the plating operation to form the UBM 904 is completed, remaining exposed portions of the seed layer 902 are etched and removed. The UBM 904 is patterned and configured to interconnect the die pad 204 by way of the RDL 502. In other embodiments, the UBM 904 may be formed by plating other metal materials.

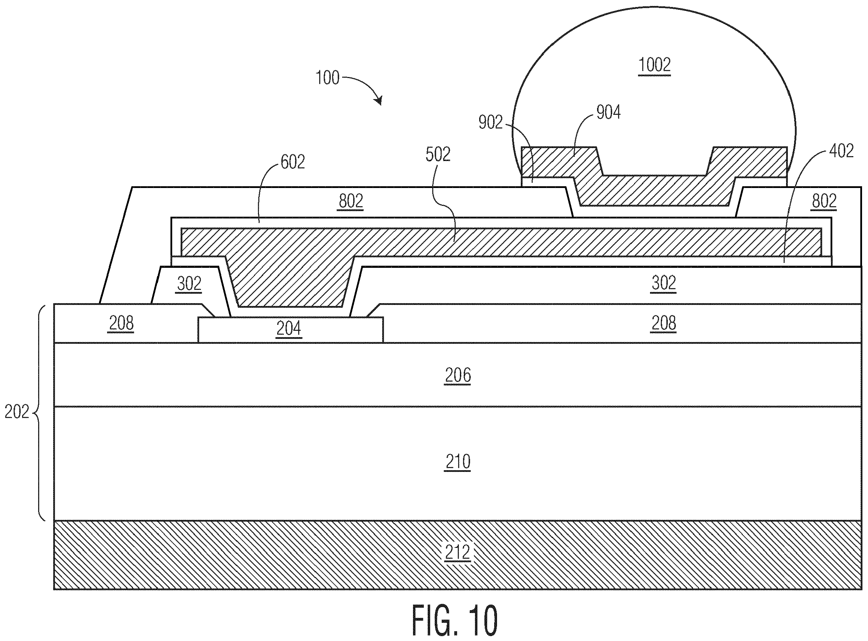

FIG. 10 illustrates, in a simplified cross-sectional view, the example semiconductor device 100 at a subsequent stage of manufacture in accordance with an embodiment. At this stage of manufacture, a conductive connector 1002 (e.g., solder ball) is attached to UBM 904. The conductive connector 1002 is placed onto the UBM 904 and reflowed, for example. A flux material may be placed on the UBM 904 before placing the conductive connector 1002 onto the UBM to improve wetting and adhesion. In this embodiment, the conductive connector 1002 is formed as a solder ball. In other embodiments, the conductive connector 1002 may be formed as a solder bump, gold stud, copper pillar, or the like.

Generally, there is provided, a method including forming a redistribution layer (RDL) over a semiconductor die, a portion of the RDL contacting a die pad of the semiconductor die; depositing a metal layer on a top surface and sidewalls of the RDL, the metal layer configured to encase the RDL; forming a non-conductive layer over the metal layer and underlying RDL; forming an opening in the non-conductive layer, the opening exposing a portion of the metal layer formed on the RDL; and forming an under-bump metallization (UBM) in the opening, the UBM conductively connected to the die pad by way of the metal layer and RDL. The RDL may be formed by way of an electroplating process. The method may further include sputtering a first seed layer over the semiconductor die before forming the RDL. The RDL may be formed having a thickness dimension in a range of 4 microns and greater. The metal layer may include a titanium, titanium-tungsten, or nickel-vanadium material. The metal layer may be formed having a thickness dimension in a range of 0.1 micron to 1.0 micron. The method may further include sputtering a second seed layer on the non-conducting layer and exposed portion of the metal layer before forming the UBM. The forming the UBM may include utilizing the second seed layer in an electroplating copper process. The non-conductive layer comprises polybenzoxazole (PBO), polyimide, Ajinomoto build-up film (ABF), or epoxy molding compound.

In another embodiment, there is provided, a semiconductor device including a semiconductor die including a die pad; a redistribution layer (RDL) formed over the semiconductor die, a portion of the RDL connected the die pad; a metal layer formed on a top surface and sidewalls of the RDL; a non-conductive layer formed on the metal layer; an opening formed in the non-conductive layer over the RDL, the opening exposing a portion of the metal layer; and an under-bump metallization (UBM) formed in the opening, the UBM conductively connected to the die pad by way of the metal layer and RDL. The semiconductor device may further include a patterned first seed layer disposed between the RDL and the semiconductor die, the RDL encased by the metal layer together with the first seed layer. The first seed layer and the metal layer may be formed from sputtered metal layers and the RDL may be formed from an electroplated copper metal layer. The semiconductor device may further include a patterned second seed layer disposed between the UBM and the metal layer. The metal layer may include a titanium, titanium-tungsten, or nickel-vanadium material. The metal layer may be formed having a thickness dimension in a range of 0.1 micron to 1.0 micron.

Herein further disclosed is a method including forming a first non-conductive layer over a semiconductor die, a first opening formed in the first non-conductive exposing a portion of a die pad of the semiconductor die; forming a redistribution layer (RDL) over the first non-conductive layer, a portion of the RDL connected to the die pad of the semiconductor die; depositing a metal layer on a top surface and sidewalls of the RDL, the metal layer configured to encase the RDL; forming a second non-conductive layer over the metal layer and underlying RDL, a second opening formed in the second non-conductive layer exposing a portion of the metal layer formed on the RDL; and forming an under-bump metallization (UBM) in the second opening, the UBM conductively connected to the die pad by way of the metal layer and RDL. The method may further include sputtering a first seed layer on the first non-conducting layer and exposed portion of the die pad before forming the RDL, the metal layer together with the first seed layer configured to encase the RDL. The forming the RDL includes utilizing the first seed layer in an electroplating copper process. The method may further include sputtering a second seed layer on the second non-conducting layer and exposed portion of the metal layer before forming the UBM. The forming the UBM includes utilizing the second seed layer in an electroplating copper process.

By now, it should be appreciated that there has been provided a semiconductor device with a redistribution metallization structure. The semiconductor device includes a plated redistribution layer formed over a semiconductor die and connected to die pads of the semiconductor die. The redistribution layer is formed by way of utilizing a sputtered metal seed layer in a plating operation. The redistribution layer is formed having a predetermined thickness sufficient to carry large currents, for example. A sputtered metal layer is formed on a top surface and sidewalls of the redistribution layer. The metal layer contacts the seed layer at a perimeter of each patterned shape of the redistribution layer. The metal layer and the seed layer together encase the redistribution layer. A dielectric layer is subsequently formed over the encased redistribution layer. An opening is formed in the dielectric layer to expose a portion of the underlying encased redistribution layer. A second seed layer is formed on the dielectric layer and exposed portion of the metal layer over the redistribution layer. An under-bump metallization is subsequently formed utilizing the second seed layer in a second plating operation. By forming the redistribution metallization structure with the plated redistribution layer encased by sputtered layers (e.g., seed layer, metal layer), improved reliability can be realized over the lifetime of the semiconductor device.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
forming a redistribution layer, RDL, over a semiconductor die, a portion of the RDL contacting a die pad of the semiconductor die;
depositing a metal layer on a top surface and sidewalls of the RDL, the metal layer configured to encase the RDL;
forming a non-conductive layer over the metal layer and underlying RDL;
forming an opening in the non-conductive layer, the opening exposing a portion of the metal layer formed on the RDL; and
forming an under-bump metallization, UBM, in the opening, the UBM conductively connected to the die pad by way of the metal layer and RDL.

2. The method of claim 1, wherein the RDL is formed by way of an electroplating process.

3. The method of claim 1 or 2, further comprising sputtering a first seed layer over the semiconductor die before forming the RDL.

4. The method of any preceding claim, wherein the RDL is formed having a thickness dimension in a range of 4 microns and greater.

5. The method of any preceding claim, wherein the metal layer comprises a titanium, titanium-tungsten, or nickel-vanadium material.

6. The method of any preceding claim, wherein the metal layer is formed having a thickness dimension in a range of 0.1 micron to 1.0 micron.

7. The method of any preceding claim, further comprising sputtering a second seed layer on the non-conducting layer and exposed portion of the metal layer before forming the UBM.

8. The method of claim 7, wherein forming the UBM includes utilizing the second seed layer in an electroplating copper process.

9. The method of any preceding claim, wherein the non-conductive layer comprises polybenzoxazole, PBO, polyimide, Ajinomoto build-up film, ABF, or epoxy molding compound.

10. A semiconductor device comprising:
a semiconductor die including a die pad;
a redistribution layer, RDL, formed over the semiconductor die, a portion of the RDL connected the die pad;
a metal layer formed on a top surface and sidewalls of the RDL;
a non-conductive layer formed on the metal layer;
an opening formed in the non-conductive layer over the RDL, the opening exposing a portion of the metal layer; and
an under-bump metallization, UBM, formed in the opening, the UBM conductively connected to the die pad by way of the metal layer and RDL.

11. The semiconductor device of claim 10, further comprising a patterned first seed layer disposed between the RDL and the semiconductor die, the RDL encased by the metal layer together with the first seed layer.

12. The semiconductor device of claim 11, wherein the first seed layer and the metal layer are formed from sputtered metal layers and the RDL is formed from an electroplated copper metal layer.

13. The semiconductor device of any of claims 10 to 12, further comprising a patterned second seed layer disposed between the UBM and the metal layer.

14. The semiconductor device of any of claims 10 to 13, wherein the metal layer includes a titanium, titanium-tungsten, or nickel-vanadium material.

15. The semiconductor device of any of claims 10 to 14, wherein the metal layer is formed having a thickness dimension in a range of 0.1 micron to 1.0 micron.
